## Europäisches Patentamt

## European Patent Office

## Office européen des brevets

(11) Numéro de publication: **0 220 120**
**B1**

## FASCICULE DE BREVET EUROPEEN

(45) Date de publication du fascicule du brevet:
11.07.90

(51) Int. Cl.⁵: **H01L 21/82,** H01L 21/28,
H01L 29/60

(21) Numéro de dépôt: 86402263.7

(22) Date de dépôt: 10.10.86

(54) Procédé de réalisation d'un dispositif à transfert de charge, et dispositif à transfert de charge mettant en oeuvre ce procédé.

(30) Priorité: 18.10.85 FR 8515503

(43) Date de publication de la demande:
29.04.87 Bulletin 87/18

(45) Mention de la délivrance du brevet:
11.07.90 Bulletin 90/28

(84) Etats contractants désignés:
DE GB NL

(56) Documents cités:
US-A- 3 795 847
US-A- 3 943 543
US-A- 4 001 861
US-A- 4 347 656

SIEMENS FORSCHUNGS- UND
ENTWICKLUNGSBERICHTE,
vol. 4, no. 4, 1975, pages 226-230, Springer-Verlag,
Berlin, DE; U. ABLASSMEIER et al.: "CCD-Schaltungen
hoher Speicherdichte in Al-Si-Gate-Technologie"

(73) Titulaire: THOMSON-CSF, 51, Esplanade du Général de
Gaulle, F-92800 Puteaux(FR)

(72) Inventeur: Blanchard, Pierre, THOMSON-CSF
SCPI 19, avenue de Messine, F-75008 Paris(FR)
Inventeur: Carquet, Michel, THOMSON-CSF
SCPI 19, avenue de Messine, F-75008 Paris(FR)
Inventeur: Warenbourg, Philippe, THOMSON-CSF
SCPI 19, avenue de Messine, F-75008 Paris(FR)

(74) Mandataire: Mayeux, Michèle et al, THOMSON-CSF
SCPI, F-92045 PARIS LA DEFENSE CEDEX 67(FR)

ACTORUM AG

## Description

L'invention concerne un procédé de réalisation d'un dispositif à transfert de charge permettant de réduire les dimensions du dispositif. Elle concerne également un dispositif à transfert de charge de faible dimension.

En utilisant une technologie de photolithogravure permettant une résolution de 2,5 µm l'actuel procédé ne permet qu'un pas de répétition minimum de 8 µm. La recherche d'une réduction de ce pas nous a conduit à un nouveau procédé.

C'est pourquoi l'invention concerne un procédé de réalisation d'un dispositif à transfert de charges comportant les différentes phases successives suivantes:

– une première phase de réalisation d'une couche d'un matériau isolant sur une face d'un substrat en matériau semiconducteur dopé;
– une deuxième phase de dépôt sur la couche de matériau isolant d'une première couche d'un matériau conducteur;
– une troisième phase de gravure dans ladite première couche de matériau conducteur de plusieurs électrodes inférieures;
– une quatrième phase de réalisation sur électrodes inférieures d'une couche d'un matériau isolant;
– une cinquième phase de dépôt sur l'ensemble ainsi obtenu d'une couche d'un matériau conducteur;
– une sixième phase de gravure, dans la couche de matériau conducteur, d'électrodes supérieures; caractérisé en ce que la troisième phase de gravure des électrodes inférieures se fait à l'aide d'un masque ayant une forme telle que les électrodes obtenues possèdent, selon un plan parallèle à une face du substrat, des élargissements et des rétrécissements, chaque élargissement d'une électrode s'imbrique entre deux élargissements de la ou des électrodes voisines de telle façon que l'espace ainsi fabriqué entre deux électrodes voisines ait une forme sinueuse et soit de largeur constante, et en ce que la sixième phase de gravure des électrodes supérieures se fait à l'aide d'un masque permettant d'obtenir des électrodes supérieures recouvrant partiellement les espaces situés entre deux électrodes voisines inférieures de telle façon qu'une électrode supérieure recouvre au moins en partie les élargissements de deux électrodes inférieures voisines.

L'invention concerne également un dispositif à transfert de charge comportant sur une face d'un substrat en semiconducteur dopé revêtu d'une couche d'un matériau isolant, des électrodes inférieures recouvertes d'un matériau isolant et possédant selon un plan parallèle à ladite face du substrat, des zones d'élargissement séparées par des zones de rétrécissement, les élargissements d'une électrode s'imbriquent dans les élargissements de la ou des électrodes voisines de façon à ce que l'espace situé entre deux électrodes ait une forme sinueuse et soit de largeur constante, chaque espace étant recouvert par une électrode supérieure de telle façon que celle-ci recouvre partiellement les élargissements d'une électrode et les élargissements d'une électrode voisine et que dans les zones du substrat situées en dessous des parties non recouvertes des rétrécissements se trouvent des barrières d'impuretés.

Les différents objets et caractéristiques de l'invention vont être détaillés en se reportant aux figures annexées qui représentent:

– la figure 1, une vue de dessus d'un dispositif à transfert de charges de type connu;
– la figure 2, une vue en coupe AA du dispositif de la figure 1;
– la figure 3, une vue de dessus d'un exemple de réalisation d'un dispositif à transfert de charges selon l'invention;
– la figure 4, une vue en coupe AA du dispositif à transfert de charges de la figure 3;
– la figure 5, une vue de dessus d'un exemple d'une variante de réalisation d'un dispositif à transfert de charges selon l'invention;
– la figure 6, une vue en coupe AA du dispositif à transfert de charges de la figure 5.

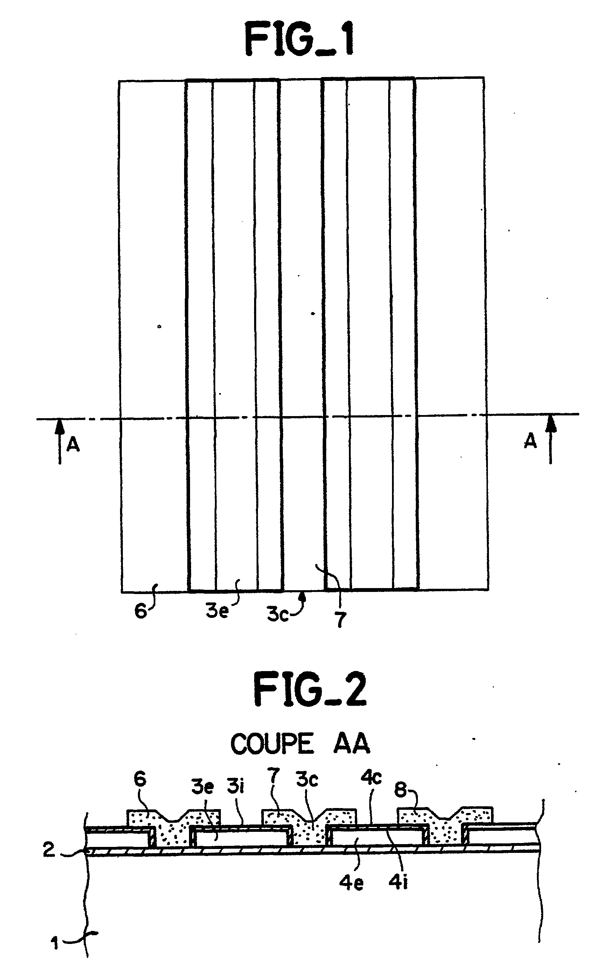

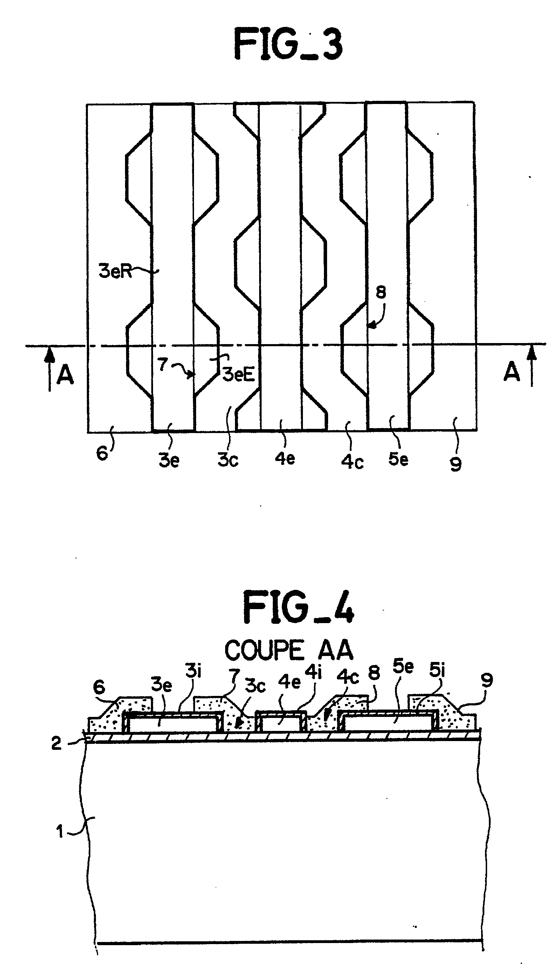

A titre de rappel et pour mettre mieux en valeur l'objet de l'invention, on va tout d'abord décrire, en se reportant aux figures 1 et 2, un dispositif à transfert de charges connu dans la technique.

Ce dispositif comporte sur une face d'un substrat 1 en matériau semiconducteur tel que du silicium dopé, une couche d'isolant tel qu'un oxyde de silicium. Sur cet oxyde 2 sont déposées des électrodes inférieures 3e et 4e recouvertes d'un isolant 3i et 4i. Ces électrodes sont rectilignes et parallèles. Elles déterminent entre elles un espace 3c. Sur les électrodes inférieures 3e, 4e et leur isolant 3i, 4i sont déposées des électrodes supérieures 6, 7 et 8, également rectilignes et parallèles, chevauchant les électrodes inférieures. L'électrode supérieure 6 située à gauche recouvre partiellement l'électrode inférieure 3e. L'électrode supérieure 7 recouvre l'espace 3c et une partie des électrodes inférieures 3e et 4e. L'électrode supérieure de droite 8 recouvre partiellement l'électrode inférieure de droite 4e.

Les électrodes inférieures 3e et 4e, dans ce type de fonctionnement définissent dans le substrat qui leur est sous-jacent des surfaces servant au stockage des charges. Les surfaces situées en dessous des électrodes supérieures 6, 7, 8 définissent des barrières et en ce qui concerne l'électrode 7, elle sert alternativement de barrière et de passage aux charges considérées.

La surface des électrodes inférieures 3e, 4e doit être la plus grande possible pour permettre le stockage d'une quantité de charges la plus importante possible.

L'électrode supérieure 7 servant de barrière et de transfert doit être de largeur dans le sens de passage des charges, la plus faible possible pour favoriser la rapidité du transfert.

L'invention concerne donc un dispositif à transfert de charges permettant d'accélérer ce transfert de charges.

En se reportant aux figures 3 et 4, on va donc décrire un dispositif à transfert de charges selon l'invention.

Selon l'invention, ce dispositif à transfert de charge est fabriqué par réalisation, au cours d'une première phase, sur un substrat 1 semiconducteur tel que du silicium, d'un isolant 2 en couche mince. Cet isolant peut être un oxyde de silicium et le procédé de réalisation est connu dans la technique.

Au cours d'une deuxième phase, on dépose une couche d'un matériau conducteur.

Puis au cours d'une troisième phase, on procède à la gravure, par photolithogravure par exemple, dans ladite couche conductrice, d'électrodes inférieures 3e et 4e. Selon l'invention, cette gravure se fait de telle façon que la géométrie des électrodes obtenues présente des élargissements et des rétrécissements. L'électrode 3e, par exemple, présente un élargissement 3eE et un rétrécissement 3eR. Les élargissements et les rétrécissements des électrodes 3e et 4e sont imbriqués les uns dans les autres, un élargissement de l'électrode 3e étant situé en face d'un rétrécissement de l'électrode 4e pour obtenir entre les deux électrodes 3e et 4e un espace 3c de largeur constante. Il en est de même de toutes les électrodes inférieures.

Au cours d'une quatrième phase, l'ensemble obtenu est recouvert d'une couche d'un matériau isolant de façon que les électrodes 3e, 4e, 5e soient recouvertes d'une couche d'isolant 3i, 4i, 5i.

Au cours d'une cinquième phase, on procède à un dépôt d'une couche d'un matériau conducteur sur l'ensemble obtenu.

Au cours d'une sixième phase, on découpe par photolithogravure par exemple, des électrodes supérieures 6, 7 et 8 recouvrant les électrodes inférieures aux emplacements des élargissements. Ces électrodes supérieures sont rectilignes et parallèles, l'électrode supérieure de gauche 6 recouvre les élargissements de gauche de l'électrode inférieure 3e. L'électrode supérieure 7 recouvre les élargissements de droite de l'électrode inférieure 3e, l'espace 3c et les élargissements de gauche de l'électrode inférieure 4e. L'électrode supérieure 8 recouvre les élargissements de droite de l'électrode inférieure 4e, l'espace 4c et les élargissements de gauche de l'électrode inférieure 5e. Enfin, l'électrode supérieure 9 recouvre les élargissements de droite de l'électrode inférieure 5e.

On obtient ainsi selon l'invention un dispositif à transfert de charge comportant, sur un substrat 1 en matériau semiconducteur et recouvert d'un isolant 2, des électrodes inférieures 3e, 4e, 5e présentant des élargissements 3eE et des rétrécissements 3eR. Ces électrodes sont disposées les unes par rapport aux autres de telle façon que leurs élargissements et leurs rétrécissements soient imbriqués les uns dans les autres.

Ces électrodes inférieures 3e, 4e, 5e sont recouvertes d'un isolant 3i, 4i, 5i. Enfin, les électrodes supérieures 6, 7, 8 recouvrent partiellement les électrodes inférieures 3e, 4e, 5e.

Ce recouvrement est tel que les électrodes supérieures recouvrent les espaces situées entre les électrodes inférieures, ainsi que les élargissements des électrodes inférieures.

De ce fait, dans le dispositif à transfert de charge de l'invention, le niveau des électrodes servant au stockage des charges de stockage est élargi et rétréci alternativement formant des sites privilégiés. Cet élargissement permet également d'assurer le recouvrement entre électrodes inférieures et supérieures permettant le passage des charges pendant le transfert.

Cependant, la gravure des électrodes supérieures peut présenter un décalage conduisant à ce que certains élargissements ne soient pas entièrement recouverts. L'invention permet de résoudre cette difficulté et permet d'admettre donc une gravure relativement peu précise des électrodes inférieures et supérieures.

En effet, à la suite de la sixième phase de gravure précédente, on prévoit une septième phase d'implantation ou de diffusion d'impuretés.

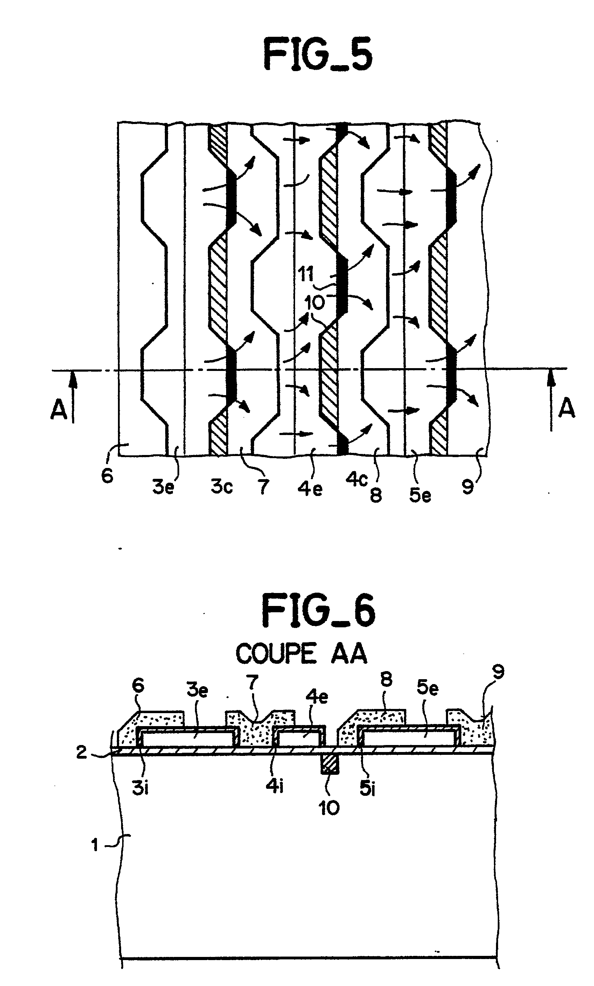

Comme représenté sur la figure 6, les électrodes supérieures 6, 7, 8, 9 peuvent être décalées sur la droite par exemple, par rapport aux électrodes inférieures 3e, 4e, 5e. Elles ne recouvrent alors qu'une partie des élargissements des électrodes inférieures. C'est ainsi, comme on peut le voir en figure 5, que l'électrode supérieure 8 ne recouvre que les parties noircies telles que 11, de l'électrode inférieure 4e. De plus, elle ne recouvre pas les parties hachurées telles que 10.

Les parties non recouvertes (parties hachurées) des espaces 3c, 4c peuvent être le siège de poches parasites de charges.

C'est pourquoi, l'invention en prévoyant une implantation ionique ou une diffusion d'impuretés conduit à la réalisation dans ces zones hachurées de barrières telles que 10 en figure 6. Cette implantation ou diffusion auto-alignée aux électrodes inférieures et supérieures empêche la création de poches parasites et interdit le passage des charges.

Lors du transfert des charges, la circulation des charges se fait par les zones situées en dessous des zones noircies des électrodes inférieures, comme cela est indiqué par les flèches mentionnées sur la figure 5.

On voit donc que selon l'invention, le fait que cette implantation soit auto-alignée aux électrodes autorise un dépositionnement du niveau des électrodes supérieures par rapport aux électrodes inférieures sans altérer le fonctionnement de la structure.

La configuration obtenue permet de réaliser une structure au pas de 6,5 μm sans modifications du processus de photolithogravure des électrodes inférieures et supérieures. Cette structure peut s'appliquer aux différents types de dispositifs à transfert de charges utilisant deux niveaux de d'électrodes.

**Revendications**

1. Procédé de réalisation d'un dispositif à transfert de charges comportant les différentes phases successives suivantes:
   - une première phase de réalisation d'une couche d'un matériau isolant (2) sur une face d'un substrat (1) en matériau semiconducteur dopé;
– une deuxième phase de réalisation sur la couche de matériau isolant (2) d'une première couche d'un matériau conducteur;
– une troisième phase de gravure dans ladite première couche de matériau conducteur de plusieurs électrodes inférieures (3e, 4e, 5e);
– une quatrième phase de réalisation sur les électrodes inférieures d'une couche d'un matériau isolant (3i, 4i, 5i);
– une cinquième phase de réalisation sur l'ensemble ainsi obtenu d'une couche d'un matériau conducteur;
– une sixième phase de gravure, dans la couche de matériau conducteur, d'électrodes supérieures (6, 7, 8, 9); caractérisée en ce que la troisième phase de gravure des électrodes inférieures (3e, 4e, 5e) se fait à l'aide d'un masque ayant une forme telle que les électrodes obtenues possèdent, selon un plan parallèle à une face du substrat, des élargissements et des rétrécissements, les élargissements d'une électrode s'imbriquant entre deux élargissements de la ou des électrodes voisines de telle façon que l'espace (3c, 4c) ainsi fabriqué entre deux électrodes voisines ait une forme sinueuse et soit de largeur constante, et en ce que la sixième phase de gravure des électrodes supérieurs (6, 7, 8, 9) se fait à l'aide d'un masque permettant d'obtenir des électrodes supérieures recouvrant partiellement les espaces (3c, 4c) situés entre deux électrodes voisines inférieures de telle façon qu'une électrode supérieure recouvre au moins en partie les élargissements de deux électrodes inférieures voisines,
– une septième phase d'implantation ou de diffusion d'impuretés.

2. Procédé selon la revendication 1, caractérisé en ce que la sixième phase permet de réaliser des électrodes supérieures telle qu'une électrode supérieure (7) recouvre en partie les élargissements d'une électrode inférieure (3e) ainsi que les élargissements en totalité et les rétrécissements d'une électrode inférieure voisine (4e).

3. Procédé de réalisation de dispositif à transfert de charges selon la revendication 1, caractérisé en ce que le matériau isolant (2) de la première phase est un oxyde de silicium.

4. Dispositif à transfert de charge comportant, sur une face d'un substrat (1) en semiconducteur dopé revêtu d'une couche d'un matériau isolant (2), des électrodes inférieures (3e, 4e, 5e) recouvertes d'un matériau isolant (3i, 4i, 5i) et possédant selon un plan parallèle à ladite face du substrat (1), des zones d'élargissement d'une électrode s'imbriquant dans les élargissements de la ou des électrodes voisines de façon à ce que l'espace (3c) situé entre deux électrodes (3e, 4e) ait une forme sinueuse et soit de largeur constante, chaque espace étant recouvert partiellement par une électrode supérieure (7) de telle façon que celle-ci recouvre partiellement les élargissements d'une électrode (3e) et les élargissements d'une électrode voisine (4e), et que dans les zones (10) du substrat (1) situées en dessous des parties non recouvertes des rétrécissements se trouvent des barrières d'impuretés.

5. Dispositif à transfert de charge selon la revendication 4, caractérisé en ce que lesdites électrodes supérieures (6, 7, 8) sont de forme rectiligne, chaque électrode supérieure, recouvrant un espace (3c) recouvre, au moins en partie les élargissements des électrodes inférieures (3e, 4e) situées de part et d'autre de l'espace (3c).

**Claims**

1 A method of producing a charge transfer device, comprising the following different successive phases:
- a first phase of the production of a layer of an insulating material (2) on one face of a substrate (1) of a doped semiconductor material;
- a second phase of the production on the layer of insulating material (2) of a first layer of a conducting material;
- a third phase of etching several lower electrodes (3e, 4e and 5e) in the said first layer of conducting material;
- a fourth phase of the production of a layer of an insulating material (3i, 4i and 5i) on the lower electrodes;
- a fifth phase of the production of a layer of a conducting material on the assembly thus produced;
- and a sixth phase of etching, in the layer of conducting material, of upper electrodes (6, 7, 8 and 9); characterized in that the third phase of etching of the lower electrodes (3e, 4e and 5e) is performed with the aid of a mask having such a form that the electrodes produced possess, considered on a plane parallel to the one face of the substrate, widened and narrowed parts, the widened parts of one electrode fitting between two respective widened parts of the neighboring electrode or electrodes in such a manner that the space (3c and 4c) thus produced between two neighboring electrodes has a winding form and has a constant width, and in that the sixth phase of etching of the upper electrodes (6, 7, 8 and 9) is performed with the aid of a mask making it possible to obtain upper electrodes partially covering the spaces (3c and 4c) situated between two lower neighboring electrodes in such a manner that an upper electrode covers at least partly the widened parts of two neighboring lower electrodes, and
- a seventh phase of implantation of diffusion of impurities.

2 The method as claimed in claim 1, characterized in that the sixth phase makes it possible to produce upper electrodes such that one upper electrode (7) partly covers the widened parts of a lower electrode (3e) and taken as a whole the widened parts and the narrowed parts and the narrowed parts of a neighboring lower electrode (4e).

3 A method of producing a charge transfer device as claimed in claim 1, characterized in that the insulating material (2) of the first phase is an oxide of silicon.

4 A charge transfer device comprising, on one face of a substrate (1) of doped semiconductor coated with a layer of an insulating material (2), lower electrodes (3e, 4e and 5e) covered by an insulating material (3i, 4i and 5i) and possessing as considered on a plane parallel to the said face of the substrate (1), widened zones of an electrode fitting into the widened parts of the neighboring electrode or electrodes (3e and 4e), has a winding form and has a constant width, each space being partly covered by an upper electrode (7) in such a manner that the layer partially covers the widened parts of an electrode (3e) and the widened parts of a neighboring electrode (4e), and in that in the zones (10) of the substrate (1) situated under non-covered parts of the narrowed parts impurity barriers are located.

5 The charge transfer device as claimed in claim 4, characterized in that the said upper electrodes (6, 7 and 8) have a rectangular form, each upper electrode, which covers a space (3c), covers, at least in part, the widened parts of the lower electrodes (3e and 4e) situated on the two sides of the space (3c).

**Patentansprüche**

1. Verfahren zur Herstellung von mit Ladungsüberführung arbeitenden Vorrichtungen, mit den folgenden aufeinanderfolgenden Verfahrensschritten:
- in einer ersten Phase wird eine Schicht aus einem isolierenden Material (2) auf einer Fläche eines Substrates (1) aus dotiertem Halbleitermaterial hergestellt;
- in einer zweiten Phase wird auf der Schicht aus isolierendem Material (2) eine erste Schicht aus einem leitfähigen Material aufgebracht;
- in einer dritten Phase werden in der ersten Schicht aus leitfähigem Material mehrere untere Elektroden (3e, 4e, 5e) graviert;
- in einer vierten Phase wird auf den unteren Elektroden eine Schicht aus Isoliermaterial (3i, 4i, 5i) gebildet;
- in einer fünften Phase wird auf der so gewonnenen Einheit eine Schicht aus leitfähigem Material gebildet;
- in einer sechsten Phase werden in der Schicht aus leitfähigem Material obere Elektroden (6, 7, 8, 9) graviert;
dadurch gekennzeichnet, daß die dritte Phase, bei der die unteren Elektroden (3e, 4e, 5e) graviert werden, mittels einer Maske ausgeführt wird, die von solcher Gestalt ist, daß die gebildeten Elektroden in einer Ebene, die parallel zu einer Fläche des Substrates ist, Verbreiterungen und Verengungen aufweisen, wobei die Verbreiterungen einer Elektrode einander mit zwei Verbreiterungen der wenigstens einen Nachbarelektrode in solcher Weise verschachteln, daß der so zwischen zwei benachbarten Elektroden hergestellte Raum (3c, 4c) eine gewundene Form aufweist und von konstanter Breite ist, und daß die sechste Phase, bei welcher die oberen Elektroden (6, 7, 8, 9) graviert werden, mittels einer Maske ausgeführt wird, die es ermöglicht, obere Elektroden herzustellen, welche die Räume (3c, 4c) zwischen zwei unteren benachbarten Elektroden teilweise überdecken, so daß eine obere Elektrode wenigstens teilweise die Verbreiterungen von zwei benachbarten unteren Elektroden überdeckt;
- eine siebte Phase, bei welcher Verunreinigungen implantiert oder eindiffundiert werden.

2. Verfahren nach Anspruch 1, dadurch gekennzeichnet, daß in der siebten Phase die oberen Elektroden in solcher Weise hergestellt werden können, daß eine obere Elektrode (7) teilweise die Verbreiterungen einer unteren Elektrode (3e) sowie die Verbreiterungen vollständig und die Verengungen einer benachbarten unteren Elektrode (4e) überdeckt.

3. Verfahren zur Herstellung einer Vorrichtung, die mit Ladungsüberführung arbeitet, gemäß Anspruch 1, dadurch gekennzeichnet, daß das isolierende Material (2) aus der ersten Phase ein Siliciumoxid ist.

4. Mit Ladungsüberführung arbeitende Vorrichtung, die auf einer Fläche eines Substrats (1) aus dotiertem Halbleiter, der mit einer Schicht aus Isoliermaterial (2) bedeckt ist, untere Elektroden (3e, 4e, 5e) aufweist, die mit einem Isoliermaterial (3i, 4i, 5i) bedeckt sind und in einer Ebene parallel zur Fläche des Substrates (1) Verbreiterungszonen einer Elektrode aufweist, die mit Verbreiterungen der wenigstens einen Nachbarelektrode verschachtelt sind, in solcher Weise, daß der zwischen zwei Elektroden (3e, 4e) gelegene Raum (3c) eine gewundene Form von konstanter Breite aufweist, wobei jeder dieser Räume teilweise durch eine obere Elektrode (7) bedeckt ist, so daß diese teilweise die Verbreiterungen einer Elektrode (3e) und die Verbreiterungen einer benachbarten Elektrode (4e) bedeckt, und daß in den Zonen (10) des Substrates (1), die unterhalb der nicht bedeckten Teile der Verengungen gelegen sind, Verunreinigungssperren vorhanden sind.

5. Ladungsüberführungs-Vorrichtung nach Anspruch 4, dadurch gekennzeichnet, daß die oberen Elektroden (6, 7, 8) von geradliniger Form sind und jede obere Elektrode, die einen Raum (3c) bedeckt, wenigstens teilweise die Verbreiterungen der unteren Elektroden (3e, 4e) bedecken, welche beiderseits des anderen Raumes (3c) gelegen sind.

# FIG_1

6   3e   3c   7

# FIG_2

## COUPE AA

6   3e   3i   7   3c   4c   8

2

4e   4i

1

# FIG_3

3eR

8

7

3eE

A          A

6    3e    3c    4e    4c    5e    9

# FIG_4

## COUPE AA

6    3e    3i    7  3c   4e  4i   4c   8   5e   5i   9

2

1

# FIG_5

6    3e    3c    7    4e    4c    8    5e    9

# FIG_6

## COUPE AA

6    3e    7    4e    8    5e    9

2

3i    4i    10    5i

1